# FASCICULE DE BREVET EUROPEEN

(11) **EP 1 883 953 B1**
(45) Date de publication et mention de la délivrance du brevet: **25.01.2012**
(21) Numéro de dépôt: 06794439.7
(22) Date de dépôt: 18.05.2006
(51) Int. Cl.: H01L 21/306

(54) **TRAITEMENT DE SURFACE APRES GRAVURE SELECTIVE**
OBERFLÄCHENBEARBEITUNG NACH SELEKTIVEM ÄTZEN
SURFACE PROCESSING AFTER SELECTIVE ETCHING

(30) Priorité: 19.05.2005 FR 0505014
(43) Date de publication de la demande: 06.02.2008
(73) Titulaire: S.O.I.Tec Silicon on Insulator Technologies, 38190 Bernin (FR)
(72) Inventeur: DELATTRE, Cécile, F-38660 Saint Hilaire Du Touvet (FR)
(74) Mandataire: Desormiere, Pierre-Louis
(86) Numéro de dépôt international: PCT/FR2006/050455
(87) Numéro de publication internationale: WO 2007/000537

(56) Documents cités:
- DRAKE T S ET AL: "Effect of rapid thermal annealing on strain in ultrathin strained silicon on insulator layers" APPLIED PHYSICS LETTERS, AIP, AMERICAN INSTITUTE OF PHYSICS, MELVILLE, NY, US, vol. 83, no. 5, 4 août 2003 (2003-08-04), pages 875-877, XP012035669 ISSN: 0003-6951
- PATENT ABSTRACTS OF JAPAN vol. 2003, no. 12, 5 décembre 2003 (2003-12-05) & JP 2005 012076 A (SUMITOMO MITSUBISHI SILICON CORP.), 13 janvier 2005 (2005-01-13)
- HATTORI T: "ENVIRONMENTALLY FRIENDLY SINGLE-WAFER SPIN CLEANING" SOLID STATE TECHNOLOGY, PENNWELL CORPORATION, TULSA, OK, US, vol. 42, no. 11, novembre 1999 (1999-11), pages 73-74,76,78,8, XP000860702 ISSN: 0038-111X

## Description

### Domaine technique et art antérieur

La présente invention concerne le nettoyage des couches de silicium contraint (sSi en abrégé pour "strained silicon") mises à nue par gravure sélective d'une couche de silicium-germanium (SiGe) comme lors de la fabrication de plaques ou "wafer" de type sSOI (silicium contraint sur isolant) ou de SGOI (silicium-germanium (SiGe) sur isolant).

Il existe plusieurs techniques d'élaboration pour de telles plaques. A titre d'exemple, l'une des plus performantes actuellement pour la fabrication de plaques de type sSOI ou SGOI est celle de la réalisation d'une couche active de silicium contraint (sSI en abrégé, pour "strained silicon") ou de SiGe relaxé par report de celle-ci sur un support isolant (par exemple couche de SiO₂ sur substrat de silicium), faisant intervenir la technologie Smart Cut™ pour réaliser l'hétérostructure désirée. Des exemples de mise en oeuvre de ces techniques de fabrication sont notamment décrits dans les documents US 2004/053477 et WO 2004/006311.

L'étape de finition de ces plaques fait intervenir un procédé de gravure sélective pour éliminer la couche de SiGe subsistant au-dessus de la couche de silicium après report de celle-ci sur le substrat "receveur" et détachement du substrat "donneur". La gravure sélective est un procédé d'attaque chimique qui permet d'éliminer de manière sélective, en jouant sur la composition de la solution chimique, en général un mélange de CH₃COOH/H₂O₂/HF, la couche supérieure de SiGe sans attaquer la couche suivante de silicium contraint.

Dans un second temps, on réalise une étape de nettoyage consistant à traiter les plaques avec des solutions de nettoyage.

Pour le nettoyage de surfaces de plaques comprenant une couche superficielle en matériau semi-conducteur, il est ainsi connu d'utiliser un traitement standard dit "RCA" qui comprend:
- une première étape de nettoyage avec une solution de SC1 (acronyme anglo-saxon de "Standard Clean 1") (ou APM acronyme anglo-saxon de "Ammonium-hydroxide Peroxide Mixture") ; contenant de l'hydroxyde d'ammonium ou ammoniac (NH₄OH), du peroxyde d'hydrogène (H₂O₂) et de l'eau dé-ionisée (H₂O).
- une deuxième étape de nettoyage avec une solution de SC2 (acronyme anglo-saxon de "Standard Clean 2") (ou HPM acronyme anglo-saxon de "Hydrochloric Peroxide Mixture"); contenant de l'acide chlorhydrique (HCl) et du peroxyde d'hydrogène (H₂O₂) et de l'eau dé-ionisée.

La première solution de SC1, généralement utilisée entre 50 et 80°C, est destinée principalement à retirer les particules isolées en surface de la plaque et les particules enterrées au voisinage de la surface, ainsi qu'à rendre la surface hydrophile.

La deuxième solution de SC2, généralement utilisée entre 70 et 90°C, est destinée principalement à retirer des contaminations métalliques qui ont pu se déposer en surface de la plaquette, en formant notamment des chlorures.

Un des inconvénients du nettoyage RCA vient de l'utilisation des solutions de SC1 et SC2. En effet, une certaine gravure ne peut être empêchée du fait de la présence d'ammoniac : la couche de silicium contraint qui a été dégagée par la gravure sélective de la couche de SiGe est ainsi gravée par la solution de nettoyage RCA. En général, la rugosité après un nettoyage standard RCA est de l'ordre de 1 à 2 Å RMS. Dans toute la description, on utilisera l'Angström (Å), qui équivaut à 0,1 nm.

Dans le cas de la réalisation de produit sSOI, la couche de silicium contraint mise à nu par la gravure est la couche utile du produit final, pour lequel les contraintes en terme de rugosité finale et d'épaisseur sont importantes. On comprend donc qu'une étape de nettoyage post gravure sélective doit satisfaire des contraintes d'efficacité d'enlèvement de particules sans être trop agressives pour ne pas détériorer la rugosité et l'épaisseur de la couche finale. En général, l'épaisseur gravée par la solution de SC1 peut aller jusqu'à 10 Å pour une couche de silicium contraint de 200 Å, en sachant qu'un nettoyage RCA grave environ 10 Å/min de silicium contraint.

L'article de Drake et al, dans Applied Physics Letters, vol. 83, n° 5 (Aout 2003), pages 875-877, décrit un procédé de fabrication d'une structure comprenant un film de silicium contraint sur isolant dans lequel le film de silicium contraint est mis à nu par gravure sélective de la couche superficielle de SiGe.

Dans le document JP-A-2005 012076 est décrit le nettoyage de couches de silicium contraint par un mélange comprenant de l'ozone après croissance de la dite couche.

### Résumé de l'invention

L'invention a pour but de remédier aux inconvénients précités et de proposer une solution de traitement de la surface de couche de silicium contraint après gravure sélective qui permet d'éliminer ou de diminuer la contamination particulaire et les défauts à la surface de la couche de silicium contraint après la gravure sélective de la couche de SiGe tout en en évitant la gravure de la couche de silicium contraint observée avec la nettoyage RCA.

Ce but est atteint avec un procédé de traitement qui comprend, après l'étape de gravure sélective de la couche de SiGe, une étape de nettoyage de la surface de la couche de silicium contraint avec une solution aqueuse d'ozone.

En effet, la Demanderesse a constaté, comme décrit plus loin en détail, que le nombre de particules et de défauts apparaissant dans la couche de silicium contraint lors de l'étape de gravure sélective est bien moins important lorsque celle-ci subi un nettoyage avec une solution aqueuse d'ozone plutôt qu'un nettoyage RCA.

Par ailleurs, en utilisant une solution de nettoyage à base d'ozone à la place d'une solution de SC1 et SC2, on évite la gravure de la couche de silicium contraint et on réduit, par conséquent, la rugosité de surface de la couche.

Selon un mode de mise en oeuvre du procédé de traitement de l'invention, la solution aqueuse d'ozone est dispensée directement sur la plaque en rotation de manière à propager la solution sur la surface de la couche de silicium contraint. Dans ce mode, l'étape de nettoyage est avantageusement réalisée avec l'équipement de traitement chimique utilisé pour l'étape de gravure sélective de sorte que l'étape de nettoyage peut être enchaînée après l'étape de gravure sélective sur l'équipement de traitement.

L'étape de nettoyage est réalisée avec une solution d'ozone dissout dans de l'eau dé-ionisée dans une concentration comprise entre 15 et 50 ppm, à la température ambiante, sur une durée comprise entre 5 secondes et 3 minutes, et avec une vitesse de rotation de la plaque comprise entre 400 et 2000 tours/minute.

Selon un aspect de l'invention, le procédé comprend en outre, après l'étape de nettoyage, une étape de rinçage à l'eau dé-ionisée qui peut être réalisée consécutivement à l'étape de nettoyage sur l'équipement de traitement chimique par voie humide.

L'étape de rinçage à l'eau dé-ionisée est réalisée à température ambiante, sur une durée comprise entre 5 secondes et 3 minutes, et avec une vitesse de rotation de la plaque comprise entre 400 et 2000 tours/minute.

Il résulte de ce procédé une plaque comprenant au moins une couche superficielle en silicium contraint, ladite couche superficielle ayant une épaisseur d'environ 200 angströms, un diamètre de 200 mm ou 300 mm, un niveau de rugosité inférieur à 1 angströms RMS pour une surface de balayage de 2*2 microns, une densité de particules inférieure à 3,2 et une densité de défauts de surface inférieure à 3,2.

Cette plaque peut comprendre une structure de silicium contraint sur isolant (sSOI).

### Brève description des figures

- les figures 1A à 1C sont des vues schématiques en perspectives montrant respectivement une étape de gravure sélective, une étape de nettoyage et une étape de rinçage conformément à un mode de mise en oeuvre de l'invention,
- la figure 2 est un histogramme montrant le taux de particules et de défauts de surface de couches de silicium contraint après gravure sélective et en fonction du type de nettoyage appliqué, et
- la figure 3 est un histogramme montrant l'état de rugosité de surface de couches de silicium contraint obtenu en fonction du type de nettoyage appliqué.

### Exposé détaillé de modes de réalisation de l'invention

Le procédé de traitement de la présente invention s'applique d'une manière générale à toute plaque ou "wafer" comprenant au moins une couche de silicium-germanium (SiGe) sur une couche de silicium contraint (sSi) mise à nu par gravure sélective de la couche de SiGe. Ce procédé de traitement peut être utilisé notamment lors de la fabrication de structures de type SSOI et SGOI par la technologie Smart Cut™ qui met en oeuvre une étape de gravure sélective de la couche de SiGe vis-à-vis de la couche de silicium contraint.

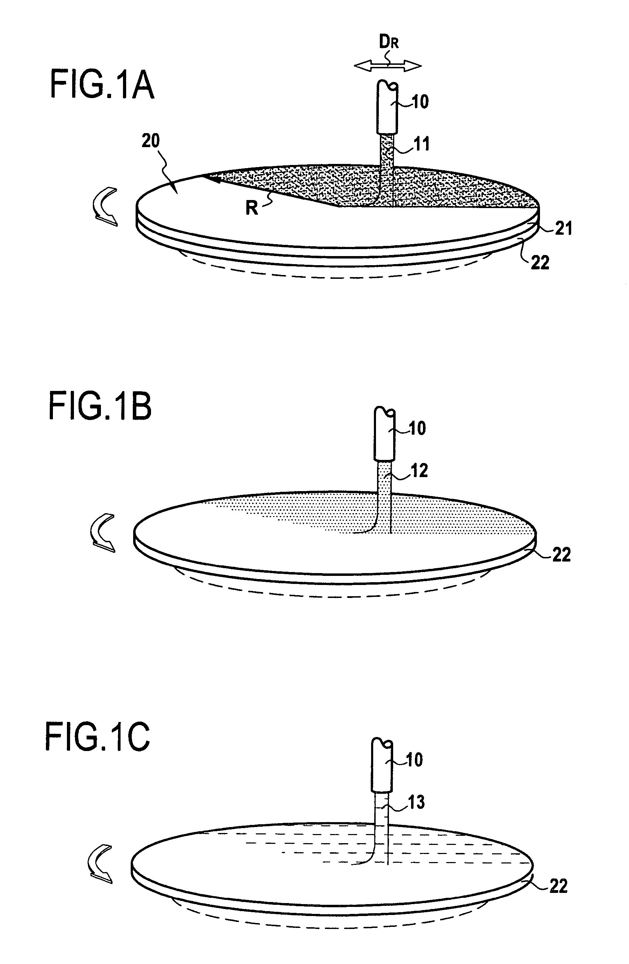

La figure 1A illustre très schématiquement un mode de mise en oeuvre de l'étape de gravure appliquée à une gravure sélective d'une couche de SiGe vis-à-vis d'une couche de silicium contraint. Dans cette étape, on utilise un équipement de traitement chimique par voie humide de type "single wafer" par lequel la gravure sélective est réalisée par dispense directe d'une solution de gravure 11 sur une seule plaque 20 comprenant en surface une couche 21 de SiGe au dessus d'une couche de silicium contraint 22, la solution étant dispensée sur la plaque 20 en rotation par une buse 10. La buse 10 est reliée à un mécanisme (non représenté) permettant de déplacer cette dernière au dessus de la plaque 20 suivant une direction radiale D_{R}. La solution de gravure 11 est par exemple constituée d'un mélange bien connu d'acide acétique (CH₃COOH), d'eau oxygénée (H₂O₂) et d'acide fluorhydrique (HF).

Une fois la couche de SiGe gravée, la surface de la couche de silicium contraint mise à nu doit être nettoyée pour réduire le nombre de particules et de défauts de surface issus de l'étape de gravure chimique.

Conformément à l'invention, cette étape de nettoyage est réalisée avec une solution aqueuse d'ozone. Comme démontré plus loin, le nettoyage avec une solution aqueuse d'ozone donne de meilleurs résultats en matière d'enlèvement de particules et de défauts de surface qu'avec les solutions de nettoyage habituellement utilisées comme les solutions de SC1 et SC2. Les principaux résidus présents à la surface de la couche de silicium sont ceux de l'acide acétique utilisée lors de l'étape de gravure sélective. Ces résidus sont enlevés lors de l'étape de nettoyage selon l'invention notamment grâce à l'action oxydante de l'ozone sur l'acide acétique suivant la formule:

CH₃COOH + 2O₃ → 2CO₂ + 2H₂O + O₂

Ce type de nettoyage se fait habituellement sur des machines qui permettent le nettoyage par lot, c'est-à-dire de plusieurs plaques à la fois. Les plaques sont immergées dans une même solution de nettoyage : on parle alors d'équipement de type "wet bench".

Toutefois, le nettoyage peut être aussi réalisé avec des équipements de type "single wafer" comme décrits précédemment pour l'étape de gravure sélective. Dans ce cas, comme illustré sur la figure 1B, le nettoyage se fait plaque par plaque, une solution aqueuse d'ozone 12 étant dispensée par la buse 10 directement sur la couche de silicium contraint 22 en rotation, de manière à propager cette solution sur la surface de la plaque. Cette solution de mise en oeuvre (i.e. nettoyage avec équipement "single wafer") permet de réaliser l'étape de nettoyage dans la continuité de la gravure sélective. En effet, immédiatement après le traitement à l'acide acétique lors de la gravure sélective, les plaques sont nettoyées avec la solution aqueuse d'ozone. Les plaques n'ont ainsi pas besoin d'être manipulées entre l'étape de gravure sélective et l'étape de nettoyage, seule la nature de la solution dispensée par la buse 10 change (solution de gravure puis solution de nettoyage).

Par ailleurs, en ce qui concerne l'efficacité d'enlèvement particulaire, il apparaît que les résultats obtenus avec l'étape de nettoyage de l'invention (i.e. avec solution aqueuse d'ozone) par rapport à un nettoyage RCA sont nettement meilleurs lorsque cette étape de nettoyage est réalisée avec un équipement de type "single wafer" plutôt qu'avec un équipement de type "wet bench".

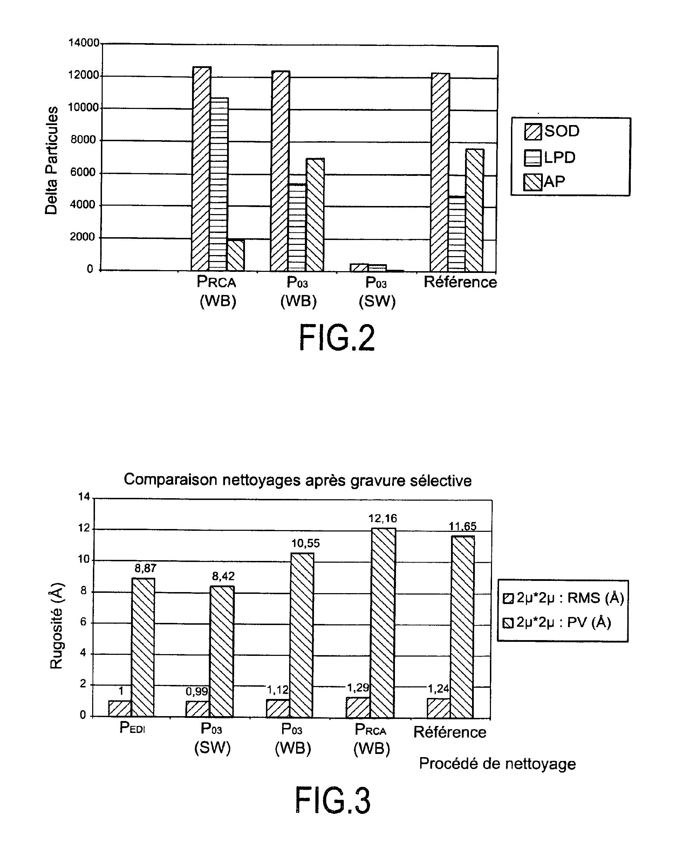

En effet, la figure 2 montre des mesures du nombre de particules (LPD pour "Light Point Defects") et d'amas de particules (AP) donnant le nombre de défauts de surface (SOD pour "Sum Of Defects") pour des plaques de 200 mm de diamètre ayant subi respectivement:
- une gravure sélective de la couche de SiGe et un nettoyage RCA dans une équipement de type "wet bench" (P_{RCA}(WB)),
- une gravure sélective de la couche de SiGe et un nettoyage avec une solution aqueuse d'ozone dans un équipement de type "wet bench" (P₀₃(WB)),
- une gravure sélective de la couche de SiGe et un nettoyage avec une solution aqueuse d'ozone dans un équipement de type "single wafer" (P₀₃(SW)), et
- seulement une gravure sélective de la couche de SiGe sans nettoyage ultérieur (Référence).

Ainsi, si l'on considère le nombre de particules (colonnes LPD sur la figure 2 qui représentent le nombre de particules détectées par mesure optique à l'aide d'un outil d'inspection laser "Light Point Defects" ou "Localized Light-Scatterer") avant et après nettoyage ainsi que l'ensemble des défauts de surface (colonnes SOD sur la figure 2 correspondant à la somme des défauts/particules LPD et AP), on remarque que le nettoyage avec une solution aqueuse d'ozone dans un équipement de type "wet bench" (P₀₃(WB)) apporte une légère amélioration par rapport au nettoyage RCA (P_{RCA}(WB)) alors qu'il devient très efficace lorsqu'il est mis en oeuvre sur un équipement de type "single wafer" (P₀₃(SW)). En effet, comme indiqué sur la figure 2, après une étape de nettoyage avec une solution aqueuse d'ozone dispensée par un équipement de type "single wafer", il reste très peu de particules (<1000, soit une densité < 3,2 particules/cm² pour une plaque de 200 mm de diamètre) et de défauts de surface (<1000, soit une densité < 3,2 particules/cm² pour une plaque de 200 mm de diamètre) au niveau de la couche de silicium contraint.

En outre, la rugosité de la surface de la couche de silicium contraint a été étudiée pour les différents types de nettoyage. La figure 3 représente l'état de rugosité de surface d'une couche de silicium contraint pour des plaques de 200 mm de diamètre ayant subi respectivement:
- une gravure sélective de la couche de SiGe et un rinçage à l'eau (P_{EDI}),
- une gravure sélective de la couche de SiGe et un nettoyage avec une solution aqueuse d'ozone dans un équipement de type "single wafer" (P₀₃(SW)),
- une gravure sélective de la couche de SiGe et un nettoyage avec une solution aqueuse d'ozone dans un équipement de type "wet bench" (P₀₃(WB)),
- une gravure sélective de la couche de SiGe et un nettoyage RCA dans une équipement de type "wet bench" (P_{RCA}(WB)), et
- seulement une gravure sélective de la couche de SiGe sans nettoyage ultérieur (Référence).

Les résultats de la figure 3 mettent en évidence que la rugosité de surface est moins importante après un nettoyage avec la solution aqueuse d'ozone plutôt qu'après un nettoyage RCA, ce qui est cohérent du fait de la composition des solutions de SC1 et SC2. En outre, pour un nettoyage avec la solution aqueuse d'ozone, la rugosité de surface est plus faible lorsque ce nettoyage est réalisé avec un équipement de type "single wafer" plutôt qu'avec un équipement de type "wet bench".

Par ailleurs, l'étape de nettoyage avec la solution aqueuse d'ozone conformément à l'invention peut être suivie d'une étape de rinçage à l'eau dé-ionisée (EDI). Comme illustré à la figure 3, cette étape de rinçage peut être réalisée avec un équipement de type "single wafer" dont la buse 10 est utilisée pour dispenser de l'eau dé-ionisée 13 sur la couche de silicium contraint 22 en rotation.

Ainsi, en utilisant un équipement de type "single wafer", les étapes de gravure sélective, de nettoyage avec une solution aqueuse d'ozone et de rinçage à l'eau dé-ionisée peuvent être enchaînées en continu l'une après l'autre, ce qui permet de réduire les temps de traitement pour chaque plaque et de réduire au maximum leur manipulation.

L'étape de gravure sélective de la couche de SiGe vis-à-vis d'une couche de silicium contraint peut être mise en oeuvre dans les conditions suivantes:
- solution de gravure sélective : CH₃COOH/H₂O₂/HF;
- température de gravure : de préférence 25°C mais pouvant varier entre 20°C et 60°C;
- durée de la gravure : de 20 secondes à 300 secondes;
- vitesse de rotation de la plaque : environ 1000 tours/minute mais pouvant varier entre 400 tours/minute et 2000 tours/minute.

L'étape de nettoyage peut être réalisée dans les conditions suivantes:
- O₃ dissout dans eau dé-ionisée de 15 ppm à 50 ppm;
- Température : de préférence température ambiante (admise à une valeur de référence de 20°C ± 5°C) mais pouvant varier entre 20°C et 30°C;
- Durée du traitement : de préférence 20 secondes mais pouvant varier de 5 secondes à 3 minutes;
- Vitesse de rotation de la plaque : de préférence 800 tours/minute mais pouvant varier de 400 tours/minute à 2000 tours/minute.

L'étape de rinçage à l'eau dé-ionisée optionnelle peut être réalisée dans les conditions suivantes:
- Température : de préférence température ambiante (admise à une valeur de référence de 20°C ± 5°C) mais pouvant varier entre 20°C et 30°C;
- Durée du traitement : de préférence 10 secondes mais pouvant varier de 5 secondes à 3 minutes;
- Vitesse de rotation de la plaque : de préférence 1000 tours/minute mais pouvant varier de 400 tours/minute à 2000 tours/minute.

La durée de nettoyage d'un traitement post gravure sélective comprenant une étape de nettoyage avec solution aqueuse d'ozone et une étape de rinçage à l'eau dé-ionisée est d'environ 30 secondes par plaques lorsqu'il est réalisée sur équipement "single wafer" ou 250 secondes par lots lorsqu'il est réalisée sur équipement "wet bench" alors que pour un traitement post gravure sélective comprenant un nettoyage RCA qui est mis en oeuvre sur équipement "wet bench", la durée est 1500 secondes par lot.

Le traitement post gravure sélective selon l'invention présente en outre un avantage non négligeable en termes de durée de traitement par rapport au nettoyage RCA que ce soit sur équipement "single wafer" que sur équipement "wet bench".

Par souci de simplification de la présente description, le procédé traitement de l'invention et les résultats obtenus avec ce dernier ont été décrits en relation avec une plaque de 200 mm de diamètre. Toutefois, l'homme du métier envisagera sans difficultés la mise en oeuvre du procédé de l'invention et l'obtention de résultats équivalents pour des plaques ("wafers") de diamètre différents et en particuliers pour des plaques ayant un diamètre de 300 mm.

## Revendications

1. Procédé de traitement de plaques (20) comprenant au moins une couche superficielle en silicium-germanium (SiGe) (21) et une couche de silicium contraint (22) en dessous de la couche de SiGe, ladite couche de silicium contraint (22) étant mise à nu par une étape de gravure sélective de la couche de SiGe, **caractérisé en ce qu'**il comprend, après la gravure sélective, une étape de nettoyage de la surface de la couche de silicium contraint avec une solution aqueuse d'ozone (12).

2. Procédé selon la revendication 1, **caractérisé en ce que**, dans l'étape de nettoyage, la solution aqueuse d'ozone (12) est dispensée directement sur la plaque (20) en rotation de manière à propager la solution sur la surface de la couche de silicium contraint (22).

3. Procédé selon la revendication 2, **caractérisé en ce que** l'étape de gravure sélective est réalisée avec un équipement de traitement chimique par voie humide comprenant des moyens d'entraînement de la plaque en rotation et des moyens de dispense (10) d'une solution de gravure (11) sur la plaque en rotation et **en ce que** l'étape de nettoyage est réalisée consécutivement à l'étape de gravure sélective sur l'équipement de traitement, la solution aqueuse d'ozone (12) étant dispensée par les moyens de dispense (10) dudit équipement.

4. Procédé selon la revendication 3, **caractérisé en ce que** l'étape de gravure sélective est réalisée avec une solution de gravure (11) comprenant un mélange d'acide acétique (CH₃COOH), d'eau oxygénée (H₂O₂) et d'acide fluorhydrique (HF), à une température comprise entre 20 et 60 °C, sur une durée comprise entre 20 et 300 secondes, et avec une vitesse de rotation de la plaque comprise entre 400 et 2000 tours/minute.

5. Procédé selon l'une quelconque des revendications 2 à 4, **caractérisé en ce que** l'étape de nettoyage est réalisée avec une solution d'ozone (12) dissout dans de l'eau dé-ionisée dans une concentration comprise entre 15 et 50 ppm, à la température ambiante, sur une durée comprise entre 5 secondes et 3 minutes, et avec une vitesse de rotation de la plaque comprise entre 400 et 2000 tours/minute.

6. Procédé selon l'une quelconque des revendications 1 à 5, **caractérisé en ce qu'**il comprend en outre une étape de rinçage à l'eau dé-ionisée (13) réalisée après l'étape de nettoyage.

7. Procédé selon l'une quelconque des revendications 3 à 5, **caractérisé en ce qu'**il comprend en outre une étape de rinçage à l'eau dé-ionisée (13) réalisée consécutivement à l'étape de nettoyage sur l'équipement de traitement chimique par voie humide, l'eau dé-ionisée (13) étant dispensée par les moyens de dispense (10) dudit équipement.

8. Procédé selon la revendication 7, **caractérisé en ce que** l'étape de rinçage à l'eau dé-ionisée est réalisée à température ambiante, sur une durée comprise entre 5 secondes et 3 minutes, et avec une vitesse de rotation de la plaque comprise entre 400 et 2000 tours/minute.

9. Procédé selon la revendication 8, **caractérisé en ce que** l'étape de nettoyage est réalisée pendant environ 20 secondes et **en ce que** l'étape de rinçage à l'eau dé-ionisée est réalisée pendant une durée d'environ 10 secondes.

## Claims

1. A method of treating wafers (20) comprising at least one surface layer of silicon-germanium (SiGe) (21) and a layer of strained silicon (22) beneath the SiGe layer, said strained silicon layer (22) being denuded by a step of selective etching of the SiGe layer, the method being **characterized in that** it comprises a step of cleaning the surface of the strained silicon layer with an aqueous ozone solution (12) following selective etching.

2. A method according to claim 1, **characterized in that** in the cleaning step, the aqueous ozone solution (12) is dispensed directly onto the rotating wafer (20) to propagate the solution over the surface of the strained silicon layer (22).

3. A method according to claim 2, **characterized in that** the selective etching step is carried out with wet chemical treatment equipment comprising means for driving the wafer in rotation and means (10) for dispensing an etching solution (11) onto the rotating wafer and **in that** the cleaning step is carried out consecutively to the selective etching step on the treatment equipment, the aqueous ozone solution (12) being dispensed via the dispensing means (10) of said equipment.

4. A method according to claim 3, **characterized in that** the selective etching step is carried out with an etching solution (11) comprising a mixture of acetic acid (CH₃COOH), hydrogen peroxide (H₂O₂) and hydrofluoric acid (HF) at a temperature in the range 20°C to 60°C, for a period in the range 20 s to 300 s and at a wafer rotation rate in the range 400 rpm to 2000 rpm.

5. A method according to any one of claims 2 to 4, **characterized in that** the cleaning step is carried out with a solution of ozone (12) dissolved in deionized water in a concentration in the range 15 ppm to 50 ppm, at ambient temperature, over a period in the range 5 s to 3 min, and at a wafer rotation rate in the range 400 rpm to 2000 rpm.

6. A method according to any one of claims 1 to 5, **characterized in that** it further comprises a step of rinsing with deionized water (13) carried out after the cleaning step.

7. A method according to any one of claims 3 to 5, **characterized in that** it further comprises a step of rinsing with deionized water (13) carried out consecutively to the cleaning step on the wet chemical treatment equipment, the deionized water (13) being dispensed by the dispensing means (10) of said equipment.

8. A method according to claim 7, **characterized in that** the deionized water rinsing step is carried out at ambient temperature, for a period in the range 5 s to 3 min, and at a wafer rotation rate in the range 400 rpm to 2000 rpm.

9. A method according to claim 8, **characterized in that** the cleaning step is carried out for about 20 seconds and **in that** the deionized water rinsing step is carried out for a period of about 10 s.

## Patentansprüche

1. Verfahren zur Behandlung von Scheiben (20), die wenigstens eine Oberflächenschicht aus Silizium-Germanium (SiGe) (21) und eine Schicht aus gestrecktem Silizium (22) unter der SiGe-Schicht umfassen, wobei die Schicht aus gestrecktem Silizium (22) mittels eines Schrittes selektiven Ätzens der SiGe-Schicht freigelegt wird, **dadurch gekennzeichnet, daß** es nach dem selektiven Ätzen einen Schritt zum Reinigen der Oberfläche der Schicht aus gestrecktem Silizium mit einer wäßrigen Ozonlösung (12) umfaßt.

2. Verfahren nach Anspruch 1, **dadurch gekennzeichnet, daß** bei dem Reinigungsschritt die wäßrige Ozonlösung (12) direkt auf die sich drehende Scheibe (20) abgegeben wird, so daß die Lösung auf der Oberfläche der Schicht aus gestrecktem Silizium (22) ausgebreitet wird.

3. Verfahren nach Anspruch 2, **dadurch gekennzeichnet, daß** der Schritt des selektiven Ätzens mit einer Einrichtung zur naßchemischen Behandlung, die Mittel zum Drehantreiben der Scheibe sowie Mittel zum Abgeben (10) einer Ätzlösung (11) auf die sich drehende Scheibe umfaßt, durchgeführt wird, und daß der Reinigungsschritt im Anschluß an den Schritt des selektiven Ätzens an der Behandlungseinrichtung durchgeführt wird, wobei die wäßrige Ozonlösung (12) durch die Abgabemittel (10) der Einrichtung abgegeben wird.

4. Verfahren nach Anspruch 3, **dadurch gekennzeichnet, daß** der Schritt des selektiven Ätzens mit einer Ätzlösung (11), die ein Gemisch aus Essigsäure (CH₃COOH), aus Wasserstoffperoxid (H₂O₂) und aus Fluorwasserstoffsäure (HF) umfaßt, bei einer Temperatur zwischen 20 und 60 °C, über eine Dauer von 20 bis 300 Sekunden und mit einer Rotationsgeschwindigkeit der Scheibe zwischen 400 und 2000 Umdrehungen/Minute durchgeführt wird.

5. Verfahren nach einem der Ansprüche 2 bis 4, **dadurch gekennzeichnet, daß** der Reinigungsschritt mit einer Lösung von in deionisiertem Wasser gelösten Ozon (12), in einer Konzentration zwischen 15 und 50 ppm, bei Raumtemperatur, über eine Dauer von 5 Sekunden bis 3 Minuten und mit einer Rotationsgeschwindigkeit der Scheibe zwischen 400 und 2000 Umdrehungen/Minute durchgeführt wird.

6. Verfahren nach einem der Ansprüche 1 bis 5, **dadurch gekennzeichnet, daß** es ferner einen Spülschritt mit deionisiertem Wasser (13) umfaßt, der nach dem Reinigungsschritt durchgeführt wird.

7. Verfahren nach einem der Ansprüche 3 bis 5, **dadurch gekennzeichnet, daß** es ferner einen Spülschritt mit deionisiertem Wasser (13) umfaßt, der im Anschluß an den Reinigungsschritt an der Einrichtung zur naßchemischen Behandlung durchgeführt wird, wobei das deionisierte Wasser (13) durch die Abgabemittel (10) der Einrichtung abgegeben wird.

8. Verfahren nach Anspruch 7, **dadurch gekennzeichnet, daß** der Spülschritt mit deionisiertem Wasser bei Raumtemperatur, über eine Dauer von 5 Sekunden bis 3 Minuten und mit einer Rotationsgeschwindigkeit der Scheibe zwischen 400 und 2000 Umdrehungen/Minute durchgeführt wird.

9. Verfahren nach Anspruch 8, **dadurch gekennzeichnet, daß** der Reinigungsschritt für etwa 20 Sekunden durchgeführt wird und daß der Spülschritt mit deionisiertem Wasser für eine Dauer von etwa 10 Sekunden durchgeführt wird.
